# FASCICULE DE BREVET EUROPEEN

(11) **EP 4 142 460 B1**
(45) Date de publication et mention de la délivrance du brevet: **17.04.2024**
(21) Numéro de dépôt: 22193097.7
(22) Date de dépôt: 31.08.2022
(51) Int. Cl.: H10N 70/20

(54) **DISPOSITIF MÉMOIRE RÉSISTIVE ET PROCÉDÉ DE RÉALISATION**
RESISTIVE SPEICHERVORRICHTUNG UND ENTSPRECHENDES HERSTELLUNGSVERFAHREN
RESISTIVE MEMORY DEVICE AND METHOD FOR MANUFACTURING THE SAME

(30) Priorité: 31.08.2021 FR 2109067
(43) Date de publication de la demande: 01.03.2023
(73) Titulaire: Commissariat à l'énergie atomique et aux énergies alternatives, 75015 Paris (FR)
(72) Inventeur: CHARPIN-NICOLLE, Christelle, 38054 Grenoble Cedex 09 (FR); BERNARD, Mathieu, 38054 Grenoble Cedex 09 (FR); GASSILLOUD, Rémy, 38054 Grenoble Cedex 09 (FR); MAGIS, Thomas, 38054 Grenoble Cedex 09 (FR)
(74) Mandataire: Hautier IP

(56) Documents cités:
- US-A1- 2015 084 156
- US-A1- 2017 271 581
- US-A1- 2019 044 065
- US-B1- 9 601 546

## Description

### DOMAINE TECHNIQUE

La présente invention concerne, en général, un dispositif mémoire résistive, et plus particulièrement, un dispositif mémoire résistive non volatile et son procédé de réalisation.

### ETAT DE LA TECHNIQUE

Les mémoires résistives de type OxRRAM (acronyme anglais de « Oxide-Based Résistive Random Access Memories » signifiant « mémoires résistives à accès aléatoire à base d'oxyde ») sont actuellement développées pour les applications non-volatiles, dans le but de remplacer les mémoires de type Flash. Elles présentent notamment pour avantage de pouvoir être intégrées dans des lignes d'interconnexion au niveau BEOL (acronyme BEOL en anglais pour « Back-End Of Line ») de la technologie CMOS (acronyme en anglais pour « Complementary Metal-Oxide-Semiconductor » signifiant technologie à base de transistors « Métal-Oxyde-Semiconducteur complémentaires »). Les mémoires résistives OxRRAM sont des dispositifs comprenant notamment une couche d'oxyde métallique disposée entre deux électrodes. La résistance électrique de ces dispositifs peut être modifiée par des opérations d'écriture et d'effacement. Ces opérations d'écriture et d'effacement permettent de faire passer le dispositif mémoire résistive OxRAM d'un état basse résistance LRS (acronyme en anglais pour « Low Résistive State ») à un état haute résistance HRS (acronyme en anglais pour « High Résistive State »), et inversement.

De cycle en cycle, les résistances des états basse résistance LRS et haute résistance HRS ne montrent pas une très bonne reproductibilité des performances. Une variabilité des performances cycle-à-cycle est en effet observée. Cette variabilité est particulièrement importante pour l'état de haute résistance HRS, induisant une diminution de la fenêtre de programmation, voire une perte totale de la fenêtre de programmation. Ce problème de variabilité est aujourd'hui un frein à l'industrialisation.

Ce souci demeure malgré de nombreux efforts réalisés dans les domaines des procédés de réalisation de dispositifs à mémoire résistive et de méthodes de programmation.

Dans une configuration classique du dispositif mémoire résistive, la couche d'oxyde métallique est intercalée en sandwich entre une première électrode, également appelée électrode inférieure, et une deuxième électrode, également appelée électrode supérieure.

Il a été montré que la réduction latérale des dimensions de cet empilement permet de réduire la variabilité des performances électriques. Cela permet en particulier de contraindre et de localiser le passage du courant à travers une zone dite filamentaire ou filament. La conduction au travers de la couche d'oxyde métallique est ainsi facilitée.

Pour contenir le filament dans une zone déterminée de largeur réduite de la couche d'oxyde métallique, une solution consiste à réduire uniquement la largeur de l'une des électrodes inférieure ou supérieure de l'empilement.

Le document US2020/0127197 A1 divulgue une formation de dispositif mémoire résistive comprenant une électrode supérieure réduite en largeur. Un inconvénient de ce dispositif et de cette méthode de formation est que la taille réduite de l'électrode supérieure engendre des problèmes de reprise de contact sur cette électrode supérieure. La mise en oeuvre du dispositif est difficile. Il apparaît ainsi que d'autres étapes complexes et coûteuses sont nécessaires pour obtenir une architecture de dispositif exploitable en pratique. Le document US2019/0044065 divulgue une formation de dispositif mémoire résistive comprenant une électrode inférieur réduite en largeur.

Un objectif de la présente invention est de pallier au moins en partie les inconvénients mentionnés ci-dessus.

Un objectif de la présente invention est de proposer un dispositif mémoire résistive présentant une variabilité HRS réduite et facile à mettre en oeuvre.

Un autre objectif de la présente invention est de proposer un procédé de fabrication d'un tel dispositif mémoire résistive, présentant un nombre d'étapes limité.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de réalisation d'un dispositif mémoire résistive comprenant au moins une première électrode et une deuxième électrode à base de matériaux d'électrodes, et une couche d'oxyde métallique intercalée entre lesdites première et deuxième électrodes selon une direction dite verticale. Le dispositif présente au moins une dimension en largeur L de préférence supérieure ou égale à 30 nm selon une direction dite horizontale d'un plan perpendiculaire à la direction verticale.

De façon avantageuse, l'une au moins parmi la première et la deuxième électrode est formée de façon à comprendre une couche intercalaire d'électrode à base d'un matériau intercalaire présentant une sélectivité S à la gravure supérieure ou égale à 2:1, et de préférence supérieure ou égale à 3:1, vis-à-vis des matériaux d'électrodes. Les matériaux d'électrodes sont à base d'un métal de transition, et le matériau intercalaire est à base d'un alliage d'aluminium et dudit métal de transition ou d'un autre métal de transition.

Le procédé comprend en outre, après formation de ladite une au moins parmi la première et la deuxième électrode comprenant la couche intercalaire d'électrode, une surgravure configurée pour consommer latéralement, selon la direction horizontale, le matériau intercalaire de sorte que la couche intercalaire d'électrode présente un retrait latéral strictement supérieur à 5 nm, et de préférence supérieur ou égal à 10 nm, vis-à-vis de l'au moins une direction en largeur L, ledit retrait latéral étant de préférence inférieur ou égal à 1/6*L.

L'étape de surgravure permet ainsi de réduire uniquement une dimension en largeur Le de la couche intercalaire d'électrode, sans réduire la dimension en largeur L du dispositif. Une partie seulement de l'électrode est ainsi réduite en largeur, ce qui permet à la fois de localiser la création du filament conducteur lors du fonctionnement du dispositif mémoire résistive, tout en permettant une bonne reprise de contact sur une autre partie de l'électrode dont la dimension en largeur L n'a pas été réduite. En particulier, la largeur de l'électrode est réduite de façon localisée au niveau de la couche intercalaire, sans que l'électrode soit réduite au sommet du dispositif. L'effet de localisation du filament est ainsi obtenu sans complexifier la reprise de contact sur le dispositif. En localisant le filament par retrait latéral, la variabilité HRS est réduite. Par ailleurs, un retrait latéral inférieur ou égal à 1/6*L permet de conserver une tension de formation du filament, appelée tension de « forming », pas trop élevée, typiquement inférieure à 3V voire à 2,5V.

Un bon compromis entre la localisation du filament et la tension de forming est ainsi obtenu. Ce type de compromis est spécifique aux dispositifs mémoire résistive de type OxRRAM et ne peut pas être déduit de solutions mises en oeuvre pour d'autres types de mémoire, notamment des mémoires à changement de phase PCRAM (acronyme anglais de « Phase Change Random Access Memories »).

La sélectivité S à la gravure correspond ici à la différence de vitesse de gravure entre le matériau intercalaire et les matériaux d'électrode, lors de la surgravure. Une sélectivité S ≥ 2:1 ou S ≥ 3:1 permet *de facto* d'obtenir un retrait latéral plus important au niveau de la couche intercalaire d'électrode lors de la surgravure. Les paramètres de l'étape de surgravure sont ici choisis, en accord avec la sélectivité S, de façon à permettre un retrait latéral de la couche intercalaire électrode d'au moins 10 nm lors de la surgravure.

Dans le cadre du développement de la présente invention, il a été observé que le pourtour du dispositif, également appelé point mémoire, présente après gravure typiquement de nombreuses singularités induisant ultérieurement une création aléatoire du filament conducteur. Ces singularités s'étendent depuis le bord du dispositif sur environ 2 à 5 nm selon la direction horizontale. Ainsi, un léger retrait latéral involontaire pouvant survenir lors d'une gravure du point mémoire n'est pas suffisant pour éviter l'influence des singularités en périphérie du point mémoire.

Au contraire, le retrait latéral selon l'invention est volontairement réalisé sur plus de 5 nm et de préférence sur au moins 10 nm pour détourer la couche intercalaire d'électrode de façon à s'affranchir des singularités en périphérie du point mémoire. Cela permet de localiser de façon maîtrisée et reproductible la création du filament conducteur lors des phases de fonctionnement ultérieur du dispositif mémoire résistive. Cela permet de limiter la variabilité de l'état de haute résistance HRS. La fenêtre de programmation du dispositif mémoire résistive est stabilisée.

Par ailleurs, l'étape de surgravure permet de limiter le nombre d'étapes total du procédé. Il n'est par exemple pas nécessaire de prévoir des étapes de lithographie supplémentaires. L'étape de surgravure peut être avantageusement réalisée en prolongement et dans la continuité d'une gravure permettant d'obtenir un dispositif de largeur L.

Selon un autre mode de réalisation, on prévoit un dispositif mémoire résistive comprenant au moins une première électrode et une deuxième électrode à base de matériaux d'électrodes, et une couche d'oxyde métallique intercalée entre lesdites première et deuxième électrodes selon une direction dite verticale. Le dispositif présente au moins une dimension en largeur L de préférence supérieure ou égale à 30 nm, selon une direction dite horizontale d'un plan perpendiculaire à la direction verticale.

Avantageusement, au moins l'une parmi les première et deuxième électrodes comprend une couche intercalaire d'électrode à base d'un matériau intercalaire présentant une sélectivité à la gravure supérieure ou égale à 2:1, et de préférence supérieure ou égale à 3:1, vis-à-vis des matériaux d'électrodes. Les matériaux d'électrodes sont à base d'un métal de transition, et le matériau intercalaire est à base d'un alliage d'aluminium et dudit métal de transition ou d'un autre métal de transition.

Avantageusement, la couche intercalaire d'électrode présente un retrait latéral strictement supérieur à 5 nm, et de préférence supérieur ou égal à 10 nm, vis-à-vis de l'au moins une direction en largeur L du dispositif, ledit retrait latéral étant inférieur ou égal à 1/6*L.

Ainsi, au moins une électrode du dispositif comprend des matériaux présentant des vitesses de gravure différentes. Cette différenciation permet de faciliter la réalisation du dispositif, et en particulier d'obtenir un retrait latéral au sein de l'électrode, au niveau de la couche intercalaire.

Le dispositif présente un retrait latéral au niveau de la couche intercalaire d'électrode d'au moins 5 nm voire d'au moins 10 nm. Une électrode du dispositif présente ainsi avantageusement au moins une dimension en largeur Le strictement inférieure à la dimension L, en partie définie par le retrait latéral. La plus petite dimension en largeur de l'électrode correspond ainsi à la dimension Le de la couche intercalaire d'électrode. Cela permet avantageusement de contraindre la formation du filament conducteur dans une zone localisée de la couche d'oxyde métallique lors du fonctionnement du dispositif mémoire résistive. La variabilité HRS est ainsi réduite. Un retrait latéral inférieur ou égal à 1/6*L permet en outre de conserver une tension de forming correcte, typiquement inférieure à 3V voire à 2,5V. La plus grande dimension en largeur d'au moins l'une des électrodes correspond à la dimension L du dispositif. Cela permet avantageusement de faciliter la reprise de contact pour la connexion ultérieure du dispositif mémoire résistive.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1 à 5 illustrent schématiquement des étapes de réalisation d'un dispositif mémoire résistive, selon un mode de réalisation de la présente invention.
La figure 6 est un agrandissement du dispositif en cours de fabrication illustrée à la figure 5.
Les figures 7 et 8 illustrent schématiquement des étapes de réalisation d'un dispositif mémoire résistive, selon un mode de réalisation de la présente invention.
La figure 9 illustre un dispositif selon un autre mode de réalisation la présente invention.
La figure 10 illustre un dispositif selon un autre mode de réalisation la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la formation de ladite une au moins parmi les première et deuxième électrodes comprenant la couche intercalaire d'électrode est configurée de sorte que la couche intercalaire d'électrode soit directement au contact de la couche d'oxyde métallique.

Selon un exemple, la couche intercalaire d'électrode est formée directement au contact de la couche d'oxyde métallique. Alternativement, l'électrode qui comprend la couche intercalaire d'électrode comprend également une portion d'électrode située entre la couche intercalaire et la couche d'oxyde métallique. Ainsi, la couche intercalaire d'électrode n'est pas au contact direct de la couche d'oxyde métallique.

Selon un exemple, la gravure de l'empilement et/ou la surgravure sont réalisés par plasma à base d'une chimie chlorée. Selon un autre exemple, le plasma peut être à base d'une chimie fluorée, ou bromée, ou iodée.

Selon un exemple, lors de la gravure de l'empilement, au moins la première électrode, la deuxième électrode et la couche d'oxyde métallique sont gravées, de préférence sur toutes leurs épaisseurs respectives.

Selon un exemple, la surgravure est réalisée en continuité de la gravure de l'empilement, en prolongeant une durée de ladite gravure.

Selon un exemple, la première électrode et la deuxième électrode sont à base, voire sont faits du même matériau. Selon un autre exemple, la première électrode et la deuxième électrode sont à base, voire sont faits de matériaux différents.

Les matériaux d'électrode sont à base d'un métal de transition, et le matériau intercalaire est à base d'un alliage d'aluminium et dudit métal de transition ou d'un autre métal de transition. Par exemple, les matériaux d'électrodes sont en TaN ou TiN. Selon un exemple, le métal de transition est pris parmi Ti, Zr, Hf, Ta, W. Le matériau intercalaire est en TixAly, ou en ZrxAly, ou en HfxAly, ou en TaxAly, ou en WxAly, avec x, y > 0.

Selon un exemple, le matériau intercalaire présente un pourcentage d'Aluminium supérieur ou égale à 25% at (en pourcentage atomique).

Selon un exemple, seule l'électrode qui comprend la couche intercalaire d'électrode est à base d'un métal de transition. L'autre électrode peut être en un autre matériau conducteur électrique. « L'électrode comprend la couche intercalaire » peut signifier que l'électrode est en contact direct avec la couche intercalaire ou que l'électrode est constituée, éventuellement uniquement, de la couche intercalaire. Selon un exemple, le matériau d'électrode est à base de TiN et le matériau intercalaire est à base de ZrAl.

Selon un exemple, la surgravure est isotrope, de sorte que le retrait latéral se forme sur tout un pourtour de la couche intercalaire d'électrode, ladite couche intercalaire d'électrode étant de préférence sensiblement centrée vis-à-vis du dispositif ou de l'empilement, en projection dans le plan xy.

Selon un exemple, la couche intercalaire d'électrode présente une épaisseur comprise entre 5 nm et 50 nm, de préférence entre 5 nm et 30 nm, de préférence entre 5 nm et 15 nm.

Selon un exemple, la couche d'oxyde métallique est à base de HfO2, les matériaux d'électrode sont à base de Ti ou de TiN, le matériau intercalaire est à base de TixAly, avec x, y > 0.

Selon un exemple, la couche intercalaire d'électrode est directement au contact de la couche d'oxyde métallique.

Selon un exemple, la couche d'oxyde métallique forme un surplomb ou une marche avec la couche intercalaire d'électrode.

Selon un exemple, la deuxième électrode comprend une couche de piégeage d'oxygène à base de Ti. Selon un exemple, la couche de piégeage d'oxygène est à base de Hf.

Selon un exemple, la couche intercalaire d'électrode forme à elle seule l'au moins une électrode parmi les première et deuxième électrodes.

Selon un exemple, l'au moins une électrode parmi les première et deuxième électrodes est uniquement constituée de la couche intercalaire d'électrode.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, une couche à base de silicium s'entend par exemple d'une couche Si, Si dopé n, Si dopé p, SiGe. Une couche à base de germanium s'entend par exemple d'une couche Ge, Ge dopé n, Ge dopé p, SiGe.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent », « intercalé » se réfèrent à des positions prises selon la direction z.

Les termes « vertical », « verticalement » se réfèrent à une direction selon z. Les termes « horizontal », « horizontalement », « latéral », « latéralement » se réfèrent à une direction dans le plan xy. Sauf mention explicite, l'épaisseur, la hauteur et la profondeur sont mesurées selon z.

Un élément situé « à l'aplomb » ou « au droit» d'un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Dans le cadre de la présente invention, on désigne par retrait horizontal ou retrait latéral un enlèvement de matière depuis une face sensiblement perpendiculaire au plan xy, selon une direction normale à cette face. Le retrait latéral d'une couche forme typiquement une marche ou un surplomb vis-à-vis des autres couches en-dessous ou au-dessus, respectivement. Le retrait latéral peut être formé sur une partie seulement du pourtour de la couche intercalaire d'électrode. Le retrait latéral peut être formé sur tout le pourtour de la couche intercalaire d'électrode. Dans ce dernier cas, selon une coupe transverse, on observe un retrait latéral de chaque côté de la couche intercalaire d'électrode, soit deux retraits latéraux (qui sont en réalité deux parties du même retrait latéral). Chaque retrait latéral est alors strictement supérieur à 5 nm, de sorte que la somme des retraits latéraux visibles en coupe transverse est strictement supérieure à 10 nm. La valeur de retrait latéral est prise localement au niveau dudit retrait latéral. Cette valeur ne correspond pas à la valeur totale des retraits latéraux visibles, mais à chacun des retraits latéraux visibles.

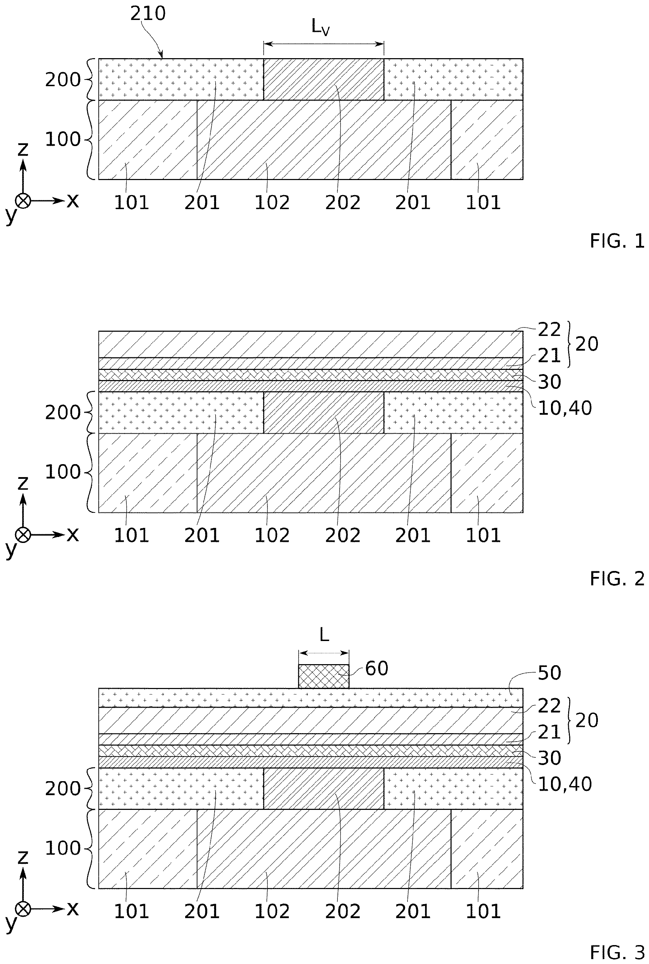

Les figures 1 à 8 illustrent un mode de réalisation du procédé de fabrication du dispositif mémoire résistive selon l'invention. Dans les exemples illustrés le dispositif mémoire résistive prend la forme d'un point mémoire de largeur L. Ce point mémoire peut s'apparenter à un cylindre vertical comprenant les première et deuxième électrodes et la couche d'oxyde métallique. Il est typiquement formé à partir d'un empilement de couches, par des étapes de dépôts, lithographie, gravures. Ces différentes étapes sont détaillées dans la suite. D'autres formes de point mémoire ou de dispositif mémoire résistive sont parfaitement envisageables, par exemple un cube ou un parallélépipède. Selon un principe de l'invention, une couche intercalaire d'électrode à base d'un matériau intercalaire est insérée dans l'empilement du point mémoire, au-dessus ou au-dessous de la couche d'oxyde métallique. Les matériaux d'électrode, l'oxyde métallique et le matériau intercalaire sont de préférence choisis tels que, dans des conditions de gravure données, la vitesse de gravure du matériau intercalaire est supérieure à la vitesse de gravure des matériaux d'électrode, et la vitesse de gravure des matériaux d'électrode est supérieure à la vitesse de gravure de l'oxyde métallique. Cela permet d'obtenir un rétrécissement du point mémoire au niveau de la couche intercalaire d'électrode.

Le dispositif mémoire résistive est typiquement formé lors des étapes technologiques de fin de ligne, dites BEOL. Ainsi, comme illustré à la figure 1, un substrat portant différents niveaux de métal et de via est fourni. Sur la figure 1 d'illustration, seuls les derniers niveaux de métal et de via sont représentés. Le niveau métal 100 comprend typiquement des lignes métalliques 102 isolées les unes des autres par un matériau diélectrique 101, typiquement du SiO2. Le niveau d'interconnexion 200 comprend typiquement des vias traversants 202 isolés les uns des autres par un matériau diélectrique 201, typiquement du SiN. Les vias 202 présentent typiquement une dimension en largeur Lv selon x. La largeur Lv des vias 202 est typiquement comprise entre quelques dizaines de nanomètres et quelques centaines de nanomètres, par exemple entre 5 et 1000 nanomètres, de préférence entre 10 et 500 nm. Une face 210 du dernier niveau 200 est exposée.

Comme illustré la figure 2, un empilement de couches est formé sur la face exposée 210. Dans cet exemple une première électrode 10, encore appelée électrode inférieure, est déposée directement au contact de la face 210. Cette électrode 10 est ici entièrement formée par la couche intercalaire d'électrode 40. Elle est de préférence à base de TixAly, avec x, y > 0, par exemple TiAl_{0,3}. Le pourcentage d'Aluminium de la couche intercalaire 40 peut varier, par exemple entre 1% et 99%. Avantageusement le pourcentage d'Aluminium de la couche intercalaire est supérieur ou égale à 25%. Cela permet d'assurer une auto-passivation de cette couche intercalaire. L'absorption d'oxygène au coeur de la couche intercalaire est ainsi évitée. Cela permet d'obtenir une résistivité électrique faible et homogène pour la couche intercalaire. La variabilité HRS et/ou LRS est ainsi réduite. Zr, Hf, Ta, W peuvent être utilisés en remplacement du Ti dans l'alliage d'aluminium de la couche intercalaire 40. Une couche d'oxyde métallique 30, généralement dénommée TMO (acronyme de Transition Metal Oxide), est ensuite déposée par-dessus la couche intercalaire d'électrode 40. Cette couche d'oxyde métallique 30 est de préférence à base de HfO2. Une deuxième électrode 20, également appelée électrode supérieure, est ensuite formée sur la couche d'oxyde métallique 30. Cette deuxième électrode 20 comprend typiquement une couche de piégeage d'oxygène 21, par exemple à base de titane, et une couche d'électrode 22, par exemple à base de TiN ou de TaN. La couche de piégeage d'oxygène 21 peut être directement au contact de la couche d'oxyde métallique 30, comme illustré sur la figure 2. L'épaisseur de la couche 40 en TixAly est de préférence comprise entre 5 nm et 50 nm. L'épaisseur de la couche d'oxyde métallique 30 à base de HfO2 est de préférence comprise entre 5 et 15 nm. L'épaisseur de la couche de piégeage d'oxygène 21 à base de Ti est de préférence comprise entre 5 et 15 nm. L'épaisseur de la couche d'électrode 22 à base de TiN est de préférence comprise entre 20 nm et 100 nm.

Selon une possibilité, la couche intercalaire d'électrode 40 est formée par une bicouche Ti/TixAly ou TixAly/Ti, l'épaisseur totale des deux couches étant comprise entre 5 nm et 15 nm.

La figure 3 illustre une étape de lithographie effectuée préalablement à la gravure de l'empilement des couches d'électrodes et d'oxyde métallique. Un motif en résine 60 est formé à l'aplomb du via 202, par exemple de façon à ce que ledit motif 60 soit centré vis-à-vis du via 202, en projection dans le plan xy. Ce motif 60 définit la forme et les dimensions, en projection dans le plan xy, du point mémoire souhaité. Il présente typiquement une dimension en largeur L. Une couche de masque dur 50, par exemple à base de SiN ou de SiO2, peut être déposé sur l'électrode supérieure 20 avant formation du motif 60. De façon connue une telle couche 50 optionnelle permet de transférer plus fidèlement la forme et les dimensions du motif 60 dans l'empilement de couches 10, 20, 30 sous-jacentes, lors de la gravure suivante. Cette couche 50 permet également de protéger l'empilement lors de certaines étapes, notamment lors de l'étape d'enlèvement de la résine, couramment désignée par « stripping » selon le vocable anglais.

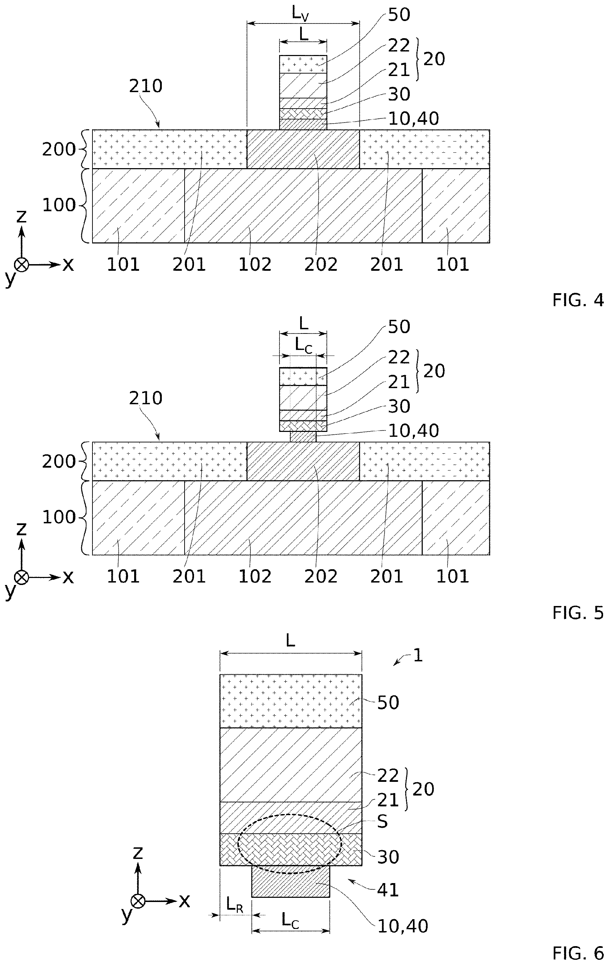

La figure 4 illustre la gravure de l'empilement des couches 20, 30, 10, respectivement. Dans cet exemple, le masque dur 50 de largeur L est représenté. Classiquement, la couche 50 est d'abord gravée de façon anisotrope selon z. Le motif 60 en résine est alors retiré. Puis l'ensemble de l'empilement des couches 20, 30, 10 est gravé de façon anisotrope selon z.

Cette dernière gravure se fait de préférence par plasma en chimie chlorée. Cela permet d'obtenir un empilement de largeur L, comprenant, depuis la face 210, une couche intercalaire d'électrode 40 à base de TixAly formant l'électrode inférieure 10, une couche d'oxyde métallique 30 à base de HfO2, une couche de piégeage d'oxygène 21 à base de Ti, une couche d'électrode supérieure 22 à base de TiN. L'arrêt de la gravure se fait de préférence sur le via 202 exposé, au niveau de la face 210.

La figure 5 illustre une étape de surgravure permettant de réduire en largeur la couche intercalaire d'électrode 40 uniquement, en conservant la dimension L pour les autres couches 30, 21, 22 de l'empilement. Lors de la surgravure, la couche intercalaire d'électrode 40 à base de TixAly se grave latéralement, selon x en coupe sur la figure 5, jusqu'à obtenir une couche 40 de dimension Lc. La surgravure se fait typiquement de part et d'autre des flancs de l'empilement, de sorte que la couche 40 reste environ centrée vis-à-vis des autres couches 30, 21, 22 de l'empilement. Lors du fonctionnement ultérieur du dispositif, le filament conducteur se formera dans une zone centrale de la couche d'oxyde métallique 30. La reproductibilité de formation du filament lors du fonctionnement du dispositif est ainsi améliorée. L'endurance du dispositif sera ainsi améliorée.

Un retrait latéral est ainsi obtenu de chaque côté de la couche 40. La surgravure est configurée de manière à ce que ce retrait latéral atteigne au moins 10 nm selon x, de chaque côté de la couche 40. Avec un tel retrait latéral, la présence de rugosité sur les flancs de l'électrode supérieure 20 ne sera plus problématique lors de la création du filament conducteur. La durée de la surgravure peut en particulier être ajustée en fonction du retrait latéral souhaité. Selon un exemple, les paramètres de la surgravure sont sensiblement les mêmes que ceux de la gravure. Selon une autre possibilité, les paramètres de la surgravure sont modifiés, par exemple de façon à ce que l'isotropie de la surgravure soit augmentée.

La figure 6 illustre schématiquement le point mémoire 1 obtenu à l'issue de la surgravure. Dans cet exemple les retraits latéraux 41 présentent chacun une dimension L_{R} ≥ 10 nm selon x. La dimension Le de la couche intercalaire 40 est égale à L - 2.L_{R}. La couche 30 forme ici un surplomb au-dessus des retraits latéraux 41. Lors des étapes ultérieures de conditionnement et de fonctionnement du dispositif 1, le filament conducteur sera formé dans la zone centrale S de la couche 30. Le filament conducteur peut se former n'importe où dans la zone centrale S de la couche 30, par exemple sur un bord de cette zone centrale S.

Cette stratégie permet donc de réduire les dimensions apparentes ou utiles du point mémoire, sans imposer de contrainte dimensionnelle supplémentaire pour la reprise de contact sur le point mémoire, de dimension L.

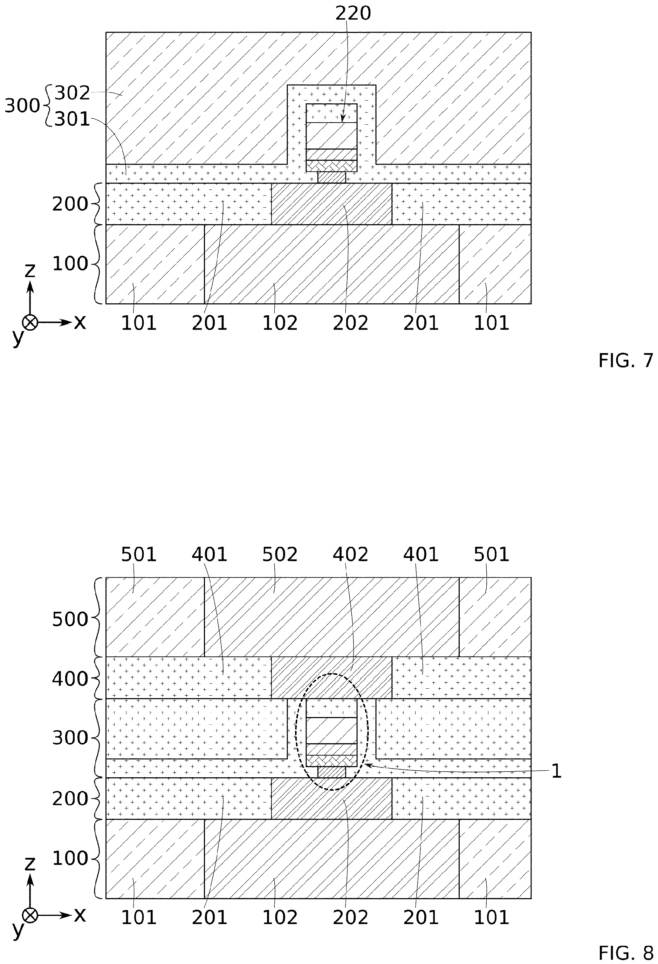

Comme illustré à la figure 7, le point mémoire est ensuite encapsulé par une ou plusieurs couches diélectriques, par exemple par une première couche 301 de SiN, puis par une deuxième couche 302 de SiO2. La première couche 301 de SiN présente par exemple une épaisseur de 30 nm. Elle est déposée de façon conforme sur le point mémoire. La couche 302 de SiO2 peut présenter une épaisseur de 300 nm. Ces couches 301, 302 forment un niveau d'encapsulation diélectrique 300 autour du point mémoire. Selon une possibilité alternative, ce niveau d'encapsulation diélectrique 300 peut être formé par une seule couche, par exemple par une couche à base de SiO2.

Après dépôt de la ou des couches diélectriques 301, 302, une étape de planarisation, par exemple par polissage mécano chimique, est effectuée de manière à exposer une face supérieure 220 de l'électrode supérieure 20.

Comme illustré à la figure 8, des niveaux de via 400 et de métal 500 sont ensuite formés après l'étape de planarisation. Cela permet de former un contact métallique sur le point mémoire 1. Le niveau d'interconnexion 400 comprend typiquement des vias traversants 402 isolés les uns des autres par un matériau diélectrique 401, typiquement du SiN. Le ou les vias 402 sont de préférence centrés vis-à-vis de l'électrode supérieure 20 du point mémoire 1. Le niveau métal 500 comprend typiquement des lignes métalliques 502 isolées les unes des autres par un matériau diélectrique 501, typiquement du SiO2.

Le dispositif 1 illustré à la figure 8 est ainsi parfaitement fonctionnel. Le contact haut formé par le via 402 et la ligne métallique 502, et le contact bas formé par le via 202 et la ligne métallique 102, peuvent être formés de façon classique, sans contraintes dimensionnelles particulières. Le dispositif 1 peut ainsi être réalisé par des étapes technologiques standard de la micro-électronique. L'introduction d'une couche intercalaire au sein d'une électrode du point mémoire, couplée à la réalisation d'une surgravure sélective de cette couche intercalaire, permet de réduire les dimensions apparentes du point mémoire à l'aplomb d'une zone centrale de la couche d'oxyde métallique du point mémoire. Ainsi, en fonctionnement, le filament conducteur sera avantageusement formé de façon localisée et reproductible au niveau de cette zone centrale.

D'autres modes de réalisation du dispositif et du procédé selon l'invention sont envisageables.

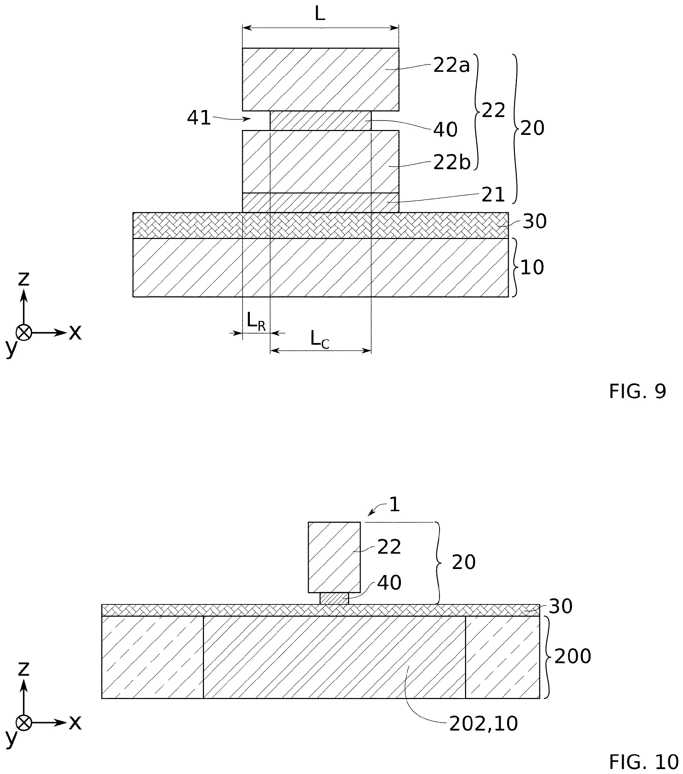

La figure 9 illustre une possibilité dans laquelle la couche intercalaire 40 est formée au sein de l'électrode supérieure 20, par exemple au sein de la couche d'électrode 22 à base de TiN. La couche intercalaire 40 à base de TixAly peut ainsi être située entre une portion supérieure 22a et une portion inférieure 22b de l'électrode supérieure 22. Dans cet exemple, la couche intercalaire 40 n'est pas au contact direct de la couche d'oxyde métallique 30.

Lorsque la couche intercalaire 40 est située au sein de l'électrode supérieure 20, la couche d'oxyde métallique 30 et/ou l'électrode inférieure 10 de l'empilement ne présentent pas nécessairement la même dimension en largeur L que l'électrode supérieure 20.

Selon un exemple de réalisation illustré à la figure 10, l'électrode inférieure 10 est directement formée par le via 202 en TiN. La couche d'oxyde métallique 30 est donc déposée directement sur le via 202. La gravure de l'empilement se limite à l'électrode supérieure 20. La couche d'oxyde métallique 30 n'est donc pas nécessairement réduite en dimensions dans le plan xy. Dans cet exemple, la couche intercalaire 40 est formée au sein de l'électrode supérieure, directement au contact de la couche d'oxyde métallique 30. Elle se substitue par exemple à la couche de piégeage d'oxygène 21 de l'électrode supérieure 20.

De nombreuses configurations d'empilement incluant une couche intercalaire 40 formant un rétrécissement dans l'une et/ou l'autre des électrodes inférieure 10 et supérieure 20 du dispositif mémoire résistive 1 sont possibles. Ces variantes ne sont pas nécessairement illustrées mais peuvent être facilement déduites par combinaison des caractéristiques des modes de réalisation décrits.

Dans tous les cas, un tel rétrécissement formé dans l'empilement permet de localiser de façon contrôlée la formation du filament conducteur dans la couche d'oxyde métallique. En particulier, le filament conducteur se forme dans une zone centrale de la couche d'oxyde métallique située à l'aplomb du centre de l'électrode inférieure et/ou de l'électrode supérieure. Cela permet d'éviter l'influence des bords des électrodes du point mémoire, sur la formation du filament conducteur. La variabilité sur la tension de formation du filament conducteur est ainsi réduite. La fiabilité du point mémoire est avantageusement améliorée. En outre, le point mémoire peut présenter une dimension apparente Le de quelques dizaines de nanomètres, tout en permettant une reprise de contact facilitée.

L'invention n'est pas limitée aux modes de réalisation précédemment décrits.

## Revendications

1. Procédé de réalisation d'un dispositif mémoire résistive (1) comprenant au moins une première électrode (10) et une deuxième électrode (20) à base de matériaux d'électrodes, et une couche d'oxyde métallique (30) intercalée entre lesdites première et deuxième électrodes (10, 20) selon une direction dite verticale (z), ledit dispositif présentant au moins une largeur L supérieure ou égale à 30 nm selon une direction dite horizontale d'un plan (xy) perpendiculaire à la direction verticale (z),
le procédé étant **caractérisé en ce que** l'une au moins parmi les première et deuxième électrodes (10, 20) est formée de façon à comprendre une couche intercalaire d'électrode (40) à base d'un matériau dit intercalaire présentant une sélectivité à la gravure supérieure ou égale à 2:1, et de préférence supérieure ou égale à 3:1, vis-à-vis des matériaux d'électrodes, les matériaux d'électrodes étant à base d'un métal de transition, et le matériau intercalaire étant à base d'un alliage d'aluminium et dudit métal de transition ou d'un autre métal de transition,
le procédé comprenant en outre, après formation de ladite une au moins parmi les première et deuxième électrodes (10, 20) comprenant la couche intercalaire d'électrode (40) :
- une surgravure configurée pour consommer latéralement, selon la direction horizontale, le matériau intercalaire de sorte que la couche intercalaire d'électrode (40) présente un retrait latéral (41) strictement supérieur à 5 nm, et de préférence supérieur ou égal à 10 nm, vis-à-vis de l'au moins une dimension en largeur L, ledit retrait latéral (41) étant inférieur ou égal à 1/6*L.

2. Procédé selon la revendication précédente dans lequel la formation de ladite une au moins parmi les première et deuxième électrodes (10, 20) comprenant la couche intercalaire d'électrode (40) est configurée de sorte que la couche intercalaire d'électrode (40) soit directement au contact de la couche d'oxyde métallique (30).

3. Procédé selon l'une quelconque des revendications précédentes dans lequel la surgravure est réalisée par plasma à base d'une chimie chlorée.

4. Procédé selon l'une quelconque des revendications précédentes dans lequel la surgravure est isotrope, de sorte que le retrait latéral (41) se forme sur tout un pourtour de la couche intercalaire d'électrode (40) en projection dans le plan (xy).

5. Procédé selon l'une quelconque des revendications précédentes dans lequel la couche intercalaire d'électrode (40) présente une épaisseur comprise entre 5 nm et 50 nm, de préférence entre 5 nm et 15 nm.

6. Procédé selon l'une quelconque des revendications précédentes dans lequel la couche d'oxyde métallique (30) est à base de HfO2, les matériaux d'électrode sont à base de Ti ou de TiN, le matériau intercalaire est à base de TixAly, avec x, y > 0.

7. Dispositif mémoire résistive (1) comprenant au moins une première électrode (10) et une deuxième électrode (20) à base de matériaux d'électrodes, et une couche d'oxyde métallique (30) disposée entre lesdites première et deuxième électrodes (10, 20) selon une direction dite verticale (z), ledit dispositif présentant au moins une largeur L supérieure ou égale à 30 nm selon une direction dite horizontale d'un plan (xy) perpendiculaire à la direction verticale (z), ledit dispositif (1) étant **caractérisé en ce que** au moins l'une parmi les première et deuxième électrodes (10, 20) comprend une couche intercalaire d'électrode (40) à base d'un matériau intercalaire présentant une sélectivité à la gravure supérieure ou égale à 2:1, et de préférence supérieure ou égale à 3:1, vis-à-vis des matériaux d'électrodes, les matériaux d'électrodes étant à base d'un métal de transition, et le matériau intercalaire étant à base d'un alliage d'aluminium et dudit métal de transition ou d'un autre métal de transition, et **en ce que** la couche intercalaire d'électrode (40) présente un retrait latéral (41) strictement supérieur à 5 nm, et de préférence supérieur ou égal à 10 nm, vis-à-vis de l'au moins une direction en largeur L, ledit retrait latéral (41) étant inférieur ou égal à 1/6*L.

8. Dispositif (1) selon la revendication précédente dans lequel le retrait latéral (41) s'étend sur tout un pourtour de la couche intercalaire d'électrode (40), de sorte que ladite couche intercalaire d'électrode (40) soit sensiblement centrée vis-à-vis du dispositif (1), en projection dans le plan (xy).

9. Dispositif (1) selon l'une quelconque des revendications 7 à 8, dans lequel la couche intercalaire d'électrode (40) est directement au contact de la couche d'oxyde métallique (30).

10. Dispositif (1) selon l'une quelconque des revendications 7 à 9 dans lequel la couche d'oxyde métallique (30) s'étend en saillie par rapport à la couche intercalaire d'électrode (40), selon une direction du plan (xy).

11. Dispositif selon l'une quelconque des revendications 7 à 10 dans lequel la deuxième électrode (20) comprend une couche de piégeage d'oxygène (21) à base de Ti.

12. Dispositif selon l'une quelconque des revendications 7 à 11 dans lequel les matériaux d'électrode sont à base de TiN, la couche d'oxyde métallique (30) est à base de HfO2, le matériau intercalaire est à base de TixAly, avec x, y > 0.

13. Dispositif selon l'une quelconque des revendications 7 à 12 dans lequel l'au moins une électrode (10, 20) parmi les première et deuxième électrodes (10, 20) est uniquement constituée de la couche intercalaire d'électrode (40).

14. Dispositif selon l'une quelconque des revendications 7 à 13 dans lequel le matériau intercalaire présente un pourcentage d'Aluminium supérieur ou égale à 25% at.

## Patentansprüche

1. Verfahren zur Herstellung einer resistiven Speichervorrichtung (1), die mindestens eine erste Elektrode (10) und eine zweite Elektrode (20) auf Basis von Elektrodenmaterialien umfasst, und eine Metalloxidschicht (30), die zwischen die erste und zweite Elektrode (10, 20) gemäß einer vertikal genannten Richtung (z) eingefügt ist, wobei die Vorrichtung mindestens eine Breite L größer oder gleich 30 mm gemäß einer horizontal genannten Richtung einer Ebene (xy) senkrecht zu der vertikalen Richtung (z) aufweist, Verfahren **dadurch gekennzeichnet, dass** mindestens eine der ersten und der zweiten Elektrode (10, 20) derart gebildet ist, dass sie eine Elektrodenzwischenschicht (40) auf Grundlage eines Zwischenmaterial genannten Materials umfasst, das eine Ätzselektivität größer oder gleich 2:1 und bevorzugt größer oder gleich 3:1 gegenüber den Elektrodenmaterialien aufweist, wobei die Elektrodenmaterialien auf einem Übergangsmetall basieren, und das Zwischenmaterial auf einer Legierung aus Aluminium und dem Übergangsmetall oder einem anderen Übergangsmetall basiert,
wobei das Verfahren außerdem nach dem Bilden der mindestens einen der ersten und der zweiten Elektrode (10, 20), die die Elektrodenzwischenschicht (40) umfasst, Folgendes umfasst:
eine Überätzung, um seitlich gemäß der horizontalen Richtung das Zwischenmaterial derart zu verbrauchen, dass die Elektrodenzwischenschicht (40) eine seitliche Schrumpfung (41) strikt größer als 5 nm und bevorzugt größer oder gleich 10 nm gegenüber dem mindestens einen Breitenmaß L aufweist, wobei die seitliche Schrumpfung (41) kleiner oder gleich 1/6*L ist.

2. Verfahren nach dem vorstehenden Anspruch, wobei das Bilden der mindestens einen der ersten und der zweiten Elektrode (10, 20), die die Elektrodenzwischenschicht (40) umfasst, derart konfiguriert ist, dass die Elektrodenzwischenschicht (40) direkt mit der Metalloxidschicht (30) in Kontakt ist.

3. Verfahren nach einem der vorstehenden Ansprüche, wobei die Überätzung durch Plasma auf Basis einer chlorhaltigen Chemie realisiert wird.

4. Verfahren nach einem der vorstehenden Ansprüche, wobei die Überätzung isotrop ist, so dass sich die seitliche Schrumpfung (41) auf einem gesamten Umfang der Elektrodenzwischenschicht (40) vorspringend in der Ebene (xy) bildet.

5. Verfahren nach einem der vorstehenden Ansprüche, wobei die Elektrodenzwischenschicht (40) eine Dicke zwischen 5 nm und 50 nm, bevorzugt zwischen 5 nm und 15 nm umfasst.

6. Verfahren nach einem der vorstehenden Ansprüche, wobei die Metalloxidschicht (30) auf HfO₂ basiert, die Elektrodenmaterialien auf Ti oder TiN basieren, das Zwischenmaterial auf TixAly basiert, wobei x, y > 0.

7. Resistive Speichervorrichtung (1), die mindestens eine erste Elektrode (10) und eine zweite Elektrode (20) auf Basis von Elektrodenmaterialien und eine Metalloxidschicht (30) umfasst, die zwischen der ersten und der zweiten Elektrode (10, 20) gemäß einer vertikal genannten Richtung (z) angeordnet ist, wobei die Vorrichtung mindestens eine Breite L größer oder gleich 30 nm gemäß einer horizontal genannten Richtung einer Ebene (xy) senkrecht zu der vertikalen Richtung (z) aufweist, Vorrichtung (1) **dadurch gekennzeichnet, dass** mindestens eine der ersten und der zweiten Elektrode (10, 20) eine Elektrodenzwischenschicht (40) auf Basis eines Zwischenmaterials umfasst, das eine Ätzselektivität größer oder gleich 2:1 und bevorzugt größer oder gleich 3:1 gegenüber den Elektrodenmaterialien aufweist, wobei die Elektrodenmaterialien auf einem Übergangsmaterial basieren, und das Zwischenmaterial auf einer Legierung aus Aluminium und dem Übergangsmetall oder einem anderen Übergangsmetall basiert, und dass die Elektrodenzwischenschicht (40) eine seitliche Schrumpfung (41) strikt größer als 5 nm und bevorzugt größer oder gleich 10 nm gegenüber der mindestens einen Richtung in die Breite L aufweist, wobei die seitliche Schrumpfung (41) kleiner oder gleich 1/6*L ist.

8. Vorrichtung (1) nach dem vorstehenden Anspruch, wobei sich die seitliche Schrumpfung (41) auf einem gesamten äußeren Umfang der Elektrodenzwischenschicht (40) derart erstreckt, dass die Elektrodenzwischenschicht (40) im Wesentlichen gegenüber der Vorrichtung (1) in der Ebene (xy) vorragend, zentriert ist.

9. Vorrichtung (1) nach einem der Ansprüche 7 bis 8, wobei die Elektrodenzwischenschicht (40) direkt mit der Metalloxidschicht (30) in Kontakt ist.

10. Vorrichtung (1) nach einem der Ansprüche 7 bis 9, wobei sich die Metalloxidschicht (30) in Bezug auf die Elektrodenzwischenschicht (40) vorragend entlang einer Richtung der Ebene (xy) erstreckt.

11. Vorrichtung nach einem der Ansprüche 7 bis 10, wobei die zweite Elektrode (20) eine Sauerstoffeinfangschicht (21) auf Basis von Ti umfasst.

12. Vorrichtung nach einem der Ansprüche 7 bis 11, wobei die Elektrodenmaterialien auf TiN basieren, die Metalloxidschicht (30) auf HfO₂ basiert, das Zwischenmaterial auf TixAly, mit x, y > 0, basiert.

13. Vorrichtung nach einem der Ansprüche 7 bis 12, wobei die mindestens eine Elektrode (10, 20) der ersten und der zweiten Elektrode (10, 20) nur aus der Elektrodenzwischenschicht (40) besteht.

14. Vorrichtung nach einem der Ansprüche 7 bis 13, wobei das Zwischenmaterial einen Prozentsatz an Aluminium größer oder gleich 25 %-at aufweist.

## Claims

1. A method for manufacturing a resistive memory device (1) comprising at least one first electrode (10) and one second electrode (20) based on electrode materials, and a metal oxide layer (30) inserted between said first and second electrodes (10, 20) in a so-called vertical direction (z), said device having at least one width L greater than or equal to 30 nm in a so-called horizontal direction of a plane (xy) perpendicular to the vertical direction (z),
the method being **characterised in that** the at least one from among the first and second electrodes (10, 20) is formed so as to comprise an electrode interlayer (40) based on a so-called divider material having an etching selectivity greater than or equal to 2:1, and preferably greater than or equal to 3:1, with respect to the electrode materials, the electrode materials being based on a transition metal, and the divider material being based on an aluminium alloy and of said transition metal or of another transition metal, the method further comprising, after formation of said at least one from among the first and second electrodes (10, 20) comprising the electrode interlayer (40):
- an overetching configured to laterally consume, in the horizontal direction, the divider material, such that the electrode interlayer (40) has a lateral removal (41) strictly greater than 5 nm, and preferably greater than or equal to 10 nm, with respect to the at least one dimension by width L, said lateral removal (41) being less than or equal to 1/6*L.

2. The method according to the preceding claim, wherein the formation of said at least one from among the first and second electrodes (10, 20) comprising the electrode interlayer (40) is configured such that the electrode interlayer (40) is directly in contact with the metal oxide layer (30).

3. The method according to any one of the preceding claims, wherein the overetching is done by a chlorinated chemistry based plasma.

4. The method according to any one of the preceding claims, wherein the overetching is isotropic, such that the lateral removal (41) is formed over the entire perimeter of the electrode interlayer (40) projecting into the plane (xy).

5. The method according to any one of the preceding claims, wherein the electrode interlayer (40) has a thickness of between 5 nm and 50 nm, preferably between 5 nm and 15 nm.

6. The method according to any one of the preceding claims, wherein the metal oxide layer (30) is HfO2-based, the electrode materials are Ti- or TiN-based, the divider material is TixAly-based, with x, y > 0.

7. A resistive memory device (1) comprising at least one first electrode (10) and one second electrode (20) based on electrode materials, and a metal oxide material (30) disposed between said first and second electrodes (10, 20) in a so-called vertical direction (z), said device having at least one width L greater than or equal to 30 nm in a so-called horizontal direction of a plane (xy) perpendicular to the vertical direction (z), said device (1) being **characterised in that** at least one from among the first and second electrodes (10, 20) comprises an electrode interlayer (40) based on a divider material having an etching selectivity greater than or equal to 2:1, and preferably greater than or equal to 3:1, with respect to the electrode materials, the electrode materials being based on a transition metal, and the divider material being based on an aluminium alloy and of said transition metal or of another transition metal, and **in that** the electrode interlayer (40) has a lateral removal (41) strictly greater than 5 nm, and preferably greater than or equal to 10 nm, with respect to the at least one direction by width L, said lateral removal (41) being less than or equal to 1/6*L.

8. The device (1) according to the preceding claim, wherein the lateral removal (41) extends over the entire perimeter of the electrode interlayer (40), such that said electrode interlayer (40) is substantially centred with respect to the device (1), projecting into the plane (xy).

9. The device (1) according to any one of claims 7 to 8, wherein the electrode interlayer (40) is directly in contact with the metal oxide layer (30).

10. The device (1) according to any one of claims 7 to 9, wherein the metal oxide layer (30) projectingly extends with respect to the electrode interlayer (40) in a direction of the plane (xy).

11. The device according to any one of claims 7 to 10, wherein the second electrode (20) comprises a Ti-based oxygen capture layer (21).

12. The device according to any one of claims 7 to 11, wherein the electrode materials are TiN-based, the metal oxide layer (30) is HfO2-based, the divider material is TixAly-based, with x, y > 0.

13. The device according to any one of claims 7 to 12, wherein the at least one electrode (10, 20) from among the first and second electrodes (10, 20) is only constituted of the electrode interlayer (40).

14. The device according to any one of claims 7 to 13, wherein the divider material has an aluminium percentage greater than or equal to 25% at.
